# EUROPEAN PATENT APPLICATION

(11) **EP 1 986 472 A2**
(43) Date of publication of application: **29.10.2008**
(21) Application number: 08075564.8
(22) Date of filing: 12.09.2002
(51) Int. Cl.: H05B 33/10, B41J 2/01, C23C 14/04, H01L 51/40

(54) **Method for patterning, method for forming film, patterning apparatus, film formation apparatus, electro-optic apparatus and method for manufacturing the same, electronic equipment, and electronic apparatus and method for manufacturing the same**

(30) Priority: 12.09.2001 JP 2001277102
(62) Divisional of application: 02765527.3
(71) Applicant: Seiko Epson Corporation, Shinjuku-ku Tokyo 163-0811 (JP)
(72) Inventor: Miyazawa, Takashi, Tokyo 392-8502 (JP)
(74) Representative: Cloughley, Peter Andrew

(57) **Abstract**

A new method for patterning in which a degree of flexibility in selection of materials is increased is provided and, in addition, a method for forming a film, a patterning apparatus, a film formation apparatus, an electro-optic apparatus and method for manufacturing the same, electronic equipment, and an electronic apparatus and method for manufacturing the same are provided.

A patterning apparatus 1 provided with a vacuum chamber 2 capable of being adjusted at a high degree of vacuum, a nozzle 3 connected to a material supply source 7 while being attached to the vacuum chamber 2 so as to supply a material from the material supply source 7 into the vacuum chamber 2, and a substrate stage 4 arranged in the vacuum chamber 2 so as to hold and fix a substrate S. The nozzle 3 or the substrate stage 4 is provided with a movement mechanism 11 for relatively moving positions thereof.

Ideally, it is desirable that a free jet of material molecules is generated, and patterning is performed using this free jet (free jet patterning). According to this, patterning can be performed with higher precision.

## Description

### Technical Field

The present invention relates to a method for patterning and a method for forming a film applicable to methods for manufacturing electro-optic apparatuses used as displays, display light sources, etc., a patterning apparatus, a film formation apparatus, an electro-optic apparatus and method for manufacturing the same, electronic equipment, and an electronic apparatus and method for manufacturing the same.

### Background Art

In recent years, regarding self-luminous displays in place of liquid crystal displays, development of organic electroluminescent elements using organic materials for luminescent layers has been accelerated. In manufacture of such an organic electroluminescent element, a method for patterning a functional material, for example, a material for forming an electroluminescent layer, into a desired pattern has been considered to be one of especially important techniques.

As processes for forming electroluminescent layers made of organic materials in the organic electroluminescent elements, a method in which a low-molecular material is made into a film by an evaporation method (refer to, for example, Non-patent literature 1) and a method in which a macromolecular material is applied by coating (refer to, for example, Non-patent literature 2) are primarily known.

Regarding the means for colorization, when low-molecular-based materials are used, a mask evaporation method has been performed, in which luminescent materials of different luminescent colors are evaporated and formed on the desired portions corresponding to pixels through a mask with a predetermined pattern. On the other hand, when macromolecular-based materials are used, colorization using an ink-jet method has been noted because patterning can be performed with fineness and with ease. Literatures disclosing manufacture of organic electroluminescent elements by such an ink-jet method have been known previously (refer to, for example, Patent literature 1 to Patent literature 4).

Regarding the organic electroluminescent elements, it has been suggested that a positive hole injection layer or positive hole transport layer has been formed between an anode and a luminescent layer in order to improve the luminous efficacy and durability (refer to, for example, Non-patent literature 1).

The aforementioned Patent literatures 1 to 4 are Japanese Unexamined Patent Application Publication No. 7-235378, Japanese Unexamined Patent Application Publication No. 10-12377, Japanese Unexamined Patent Application Publication No. 11-40358, and Japanese Unexamined Patent Application Publication No. 11-54270, respectively, and Non-patent literatures 1 and 2 are Appl. Phys. Lett. 51(12), 21 September 1987, p. 913 and Appl. Phys. Lett. 71(1), 7 July 1997, p. 34, respectively.

Regarding manufacture of such an organic electroluminescent element, etc., provision of new methods for patterning in which, especially, a degree of flexibility in selection of materials is increased has been required because of diversification of materials for various constituents, and the like.

Accordingly, it is an object of the present invention to provide a new method for patterning in which a degree of flexibility in selection of materials is increased and, in addition, to provide a method for forming a film, a patterning apparatus, a film formation apparatus, an electro-optic apparatus and method for manufacturing the same, electronic equipment, and an electronic apparatus and method for manufacturing the same.

### Disclosure of Invention

In order to achieve the aforementioned objects, a method for patterning of the present invention includes the steps of arranging a substrate in a vacuum atmosphere adjusted at a high degree of vacuum, and discharging a material into the aforementioned vacuum atmosphere from a nozzle connected to a material supply source so as to form a pattern made of the aforementioned material on the aforementioned substrate.

In this method for patterning, when the material is discharged into the vacuum atmosphere which is an atmosphere at a pressure adequately lower than that in the nozzle, this material can be discharged in the condition of being vaporized and ideally in the shape of a molecular beam. Therefore, patterning can be performed without the need for any mask by discharging this material onto the substrate while relative positions of the nozzle and the substrate are controlled. Consequently, each of low-molecular-based materials and macromolecular-based materials can be patterned without particular restriction.

Another method for patterning of the present invention includes the steps of arranging a substrate in a vacuum atmosphere adjusted at a high degree of vacuum, and discharging a material into the aforementioned vacuum atmosphere from at least one of a plurality of nozzles connected to a material supply source so as to form a pattern made of the aforementioned material on the aforementioned substrate.

In this method for patterning, when the material is discharged into the vacuum atmosphere which is an atmosphere at a pressure adequately lower than that in the nozzle, this material can be discharged in the condition of being vaporized and ideally in the shape of a molecular beam. Therefore, patterning can be performed without the need for any mask by discharging this material onto the substrate while relative positions of the nozzle and the substrate are controlled. Consequently, each of low-molecular-based materials and macromolecular-based materials can be patterned without particular restriction.

Since a plurality of nozzles are connected to the material supply source, it becomes possible to enlarge the region in which the material can be arranged at a time, to increase the quantity of supply of the material on a span of time basis, or to discharge simultaneously different materials and, therefore, improvement of throughput can be achieved.

In this method for patterning, the same aforementioned material may be discharged from at least two of the aforementioned plurality of nozzles.

According to this, by discharging the same material from at least two nozzles, for example, it becomes possible to enlarge the region in which the material can be arranged at a time and to arrange the material in a plurality of regions at a time and, in addition, the quantity of supply of the material on a span of time basis can be increased.

In this method for patterning, the aforementioned nozzle may be positioned relative to the aforementioned substrate by relatively moving the aforementioned nozzle and the aforementioned substrate.

According to this, by relatively moving a plurality of nozzles and the substrate so as to position the plurality of nozzles relative to the substrate, the material can be arranged at a predetermined position on the substrate with reliability. The material can be arranged at a plurality of positions on the substrate with ease.

In the aforementioned method for patterning, preferably, discharge of the material from the aforementioned nozzle into the vacuum atmosphere is performed while the material is in the condition of being vaporized in the vacuum atmosphere.

Ideally, it is preferable that the material is discharged in the shape of a molecular beam. According to this, since the material is vaporized and, therefore, can be used without the need for any solvent, even a material unlikely to dissolve into a solvent can be patterned with further reliability without particular restriction.

In the aforementioned method for patterning, discharge of the material from the aforementioned nozzle may be performed intermittently.

According to this, for example, discontinuous pattern can be formed and, therefore, when this method is applied to, for example, manufacture of an organic electroluminescent element, materials for forming a luminescent layer, etc., can be patterned onto many independent pixels with ease.

In the aforementioned method for patterning, preferably, the material is discharged from the nozzle while accompanying a carrier gas.

According to this, for example, by allowing the material to accompany the carrier gas, this material can be discharged with reliability and, in addition, be arranged at a desired position with further reliability. Consequently, the precision of patterning can be improved.

In the aforementioned method for patterning, the degree of vacuum required basically depends on the material to be discharged from the nozzle, and regarding low-boiling point materials, 730 Torr (98,000 Pa) or less may be adequate. However, regarding general materials, the aforementioned vacuum atmosphere is adjusted preferably at a degree of vacuum of 10 Torr (0.133 Pa) or less, and more preferably, is adjusted at a degree of vacuum of 10 Torr (0.00133 Pa) or less. When the vacuum atmosphere is adjusted at 10 Torr (0.133 Pa) or less, for example, even a material unlikely to be discharged can be discharged with ease, and when adjusted at 10 ⁻⁵ Torr (0.00133 Pa) or less, still more sorts of materials can be discharged and, in addition, the materials discharged can be vaporized so as to easily take the shape of a molecular beam.

A first method for forming a film of the present invention includes a first step of discharging a material into an atmosphere adjusted at a predetermined degree of vacuum from a nozzle connected to a material supply source so as to form a film containing the aforementioned material or a film containing the material as the precursor, on a first region of a substrate, and a second step of discharging the aforementioned material into the aforementioned atmosphere from the aforementioned nozzle so as to form a film containing the aforementioned material or a film containing the material as the precursor, on a second region different from the first region.

In the aforementioned method for forming a film, preferably, the aforementioned first step and the aforementioned second step are performed continuously in an atmosphere adjusted at the aforementioned predetermined degree of vacuum without reducing to atmospheric pressure. According to this, contamination of impurities from the outside can be reduced and, at the same time, films can be formed in accordance with a plurality of regions on the aforementioned substrate.

A second method for forming a film of the present invention includes the steps of discharging a material into a vacuum atmosphere from a first nozzle connected to a material supply source so as to form a film containing the aforementioned material or a film containing the material as the precursor, on a first region of a substrate, and at the same time, discharging the aforementioned material into the aforementioned atmosphere from a second nozzle connected to the aforementioned material supply source so as to form a film containing the aforementioned material or a film containing the material as the precursor, on a second region different from the aforementioned first region.

According to the aforementioned second method for forming a film, since films can be formed on the plurality of regions of the aforementioned substrate at the same time, reduction of the film formation step can be achieved.

A third method for forming a film of the present invention includes the steps of discharging a first material into a vacuum atmosphere from a first nozzle connected to a first material supply source so as to form a film containing the aforementioned first material or a film containing the material as the precursor, on a first region of the aforementioned substrate, and at the same time, discharging a second material into the aforementioned atmosphere from a second nozzle connected to a second material supply source so as to form a film containing the second material or a film containing the material as the precursor, on a second region different from the aforementioned first region.

According to the aforementioned third method for forming a film, since films having different compositions can be formed on the plurality of regions of the aforementioned substrate at the same time, reduction of the film formation step can be achieved.

In the aforementioned method for forming a film, the degree of vacuum required basically depends on the material to be discharged from the nozzle, and regarding low-boiling point materials, 730 Torr (98,000Pa) or less may be adequate. However, regarding general materials, the aforementioned vacuum atmosphere is adjusted preferably at a degree of vacuum of 10⁻³ Torr (0.133 Pa) or less, and more preferably, is adjusted at a degree of vacuum of 10⁻⁵ Torr (0.00133 Pa) or less.

A patterning apparatus of the present invention is provided with a vacuum chamber capable of being adjusted at a high degree of vacuum, a nozzle connected to a material supply source while being attached to the aforementioned vacuum chamber so as to supply a material in the condition of being vaporized from the aforementioned material supply source into the vacuum chamber, and a substrate stage arranged in the aforementioned vacuum chamber so as to hold and fix a substrate, wherein the aforementioned nozzle or substrate stage is provided with a movement mechanism for moving relative positions of the aforementioned nozzle and the aforementioned substrate stage.

According to this patterning apparatus, when the material is discharged into the vacuum chamber in which a pressure of the atmosphere becomes adequately lower than that in the nozzle, this material can be discharged with ease and with stability. Therefore, patterning can be performed without the need for any mask by ejecting this material onto the substrate while relative positions of the nozzle and the substrate are moved with a movement mechanism. Consequently, each of low-molecular-based materials and macromolecular-based materials can be patterned without particular restriction.

Another patterning apparatus of the present invention is provided with a vacuum chamber capable of being adjusted at a high degree of vacuum, a plurality of nozzles connected to a material supply source while being attached to the aforementioned vacuum chamber so as to supply the material from the aforementioned material supply source into the vacuum chamber, and a substrate stage arranged in the aforementioned vacuum chamber so as to hold and fix a substrate, wherein the aforementioned nozzle or substrate stage is provided with a movement mechanism for moving relative positions of the aforementioned nozzle and the aforementioned substrate stage.

According to this patterning apparatus, when the material is discharged into the vacuum chamber in which a pressure of the atmosphere becomes adequately lower than that in the nozzle, this material can be discharged with ease and with stability. Therefore, patterning can be performed without the need for any mask by ejecting this material onto the substrate while relative positions of the nozzle and the substrate are moved with a movement mechanism. Consequently, each of low-molecular-based materials and macromolecular-based materials can be patterned without particular restriction.

Since a plurality of nozzles are arranged, it becomes possible to enlarge the region in which the material can be arranged at a time, to increase the quantity of supply of the material on a span of time basis, or to discharge simultaneously different materials and, therefore, improvement of throughput can be achieved.

In the aforementioned patterning apparatus, preferably, the relative positions of the aforementioned plurality of nozzles and the aforementioned substrate can be controlled. Examples of this control include, for example, to relatively control the position of the aforementioned nozzle and the position of the aforementioned substrate in the horizontal direction. According to this, the film can be formed selectively at a desired position of the aforementioned substrate. Furthermore, the area of the region to be provided with the film can be set appropriately by controlling the distance between the aforementioned nozzle and the aforementioned substrate. In particular, in the case where the material becomes a molecular beam or in the condition of supersonic molecular effusion (supersonic free jet) when being discharged from the nozzle, the spatial expansion of the material has an especially strong positive correlation with the nozzle diameter, and has an especially strong positive correlation with the distance from the nozzle. Consequently, when the nozzle diameter is constant, the area of formation of the film can be determined with precision to some extent by controlling the distance between the nozzle and the substrate.

In this patterning apparatus, preferably, at least two of the aforementioned plurality of nozzles discharge the same aforementioned material.

According to this, by discharging the same material from at least two nozzles, the region in which the material can be arranged at a time can be enlarged, and the quantity of supply of the material on a span of time basis can be increased.

In this patterning apparatus, preferably, at least two of the aforementioned plurality of nozzles discharge the aforementioned materials different from each other.

According to this, by discharging the materials different from each other from the plurality of nozzles, the film composed of a plurality of materials different from each other can be formed on the substrate. In this case, a plurality of material films different from each other are arranged in a predetermined arrangement pattern, or a plurality of materials different from each other are mixed and, therefore, a functional film having a specific function can be formed on the substrate.

In the aforementioned patterning apparatus, preferably, a heating device for heating the material is arranged on the material supply source side of the aforementioned nozzle.

According to this configuration, by heating beforehand the material to be supplied to the nozzle with a heating device, the material can become likely to vaporize during discharge and, therefore, even a material relatively unlikely to vaporize can be vaporized with ease, and patterning can be performed.

In the aforementioned patterning apparatus, preferably, a carrier gas supply source is arranged on the material supply source side of the aforementioned nozzle.

According to this configuration, by allowing the material discharged in the shape of a molecular beam to accompany the carrier gas from the carrier gas supply source, it is possible to arrange the material at a desired position with further reliability and, therefore, precision of the patterning can be improved.

A method for manufacturing an electro-optic apparatus of the present invention includes the step of patterning at least a part of constituents by using the aforementioned method for patterning or method for forming a film.

According to this method for manufacturing an electro-optic apparatus, by applying a coating of the material on the substrate while relative positions of the nozzle and the substrate are controlled as described above, patterning can be performed without the need for any mask. Consequently, even the material unlikely to dissolve into a solvent can be patterned without particular restriction.

A method for manufacturing an electronic apparatus of the present invention includes the step of patterning at least a part of constituents by using the aforementioned method for patterning or method for forming a film.

According to this method for manufacturing an electronic apparatus, by applying a coating of the material on the substrate while relative positions of the nozzle and the substrate are controlled as described above, patterning can be performed without the need for any mask. Consequently, even the material unlikely to dissolve into a solvent can be patterned without particular restriction.

A first film formation apparatus of the present invention is provided with a vacuum chamber capable of being adjusted at a predetermined degree of vacuum, a nozzle connected to a material supply source while being attached to the aforementioned vacuum chamber so as to supply a material from the aforementioned material supply source into the vacuum chamber, a substrate stage arranged in the aforementioned vacuum chamber so as to hold and fix a substrate, and a movement mechanism for moving at least one of the aforementioned nozzle and substrate stage, wherein relative positions of the aforementioned nozzle and the aforementioned substrate stage can be controlled by the aforementioned movement mechanism.

A second film formation apparatus of the present invention is provided with a vacuum chamber capable of being adjusted at a predetermined degree of vacuum, a plurality of nozzles connected to a material supply source while being attached to the aforementioned vacuum chamber so as to supply a material from the aforementioned material supply source into the aforementioned vacuum chamber, a substrate stage arranged in the aforementioned vacuum chamber so as to hold and fix a substrate, and a movement mechanism for moving at least one of the aforementioned plurality of nozzles and substrate stage, wherein relative positions of the aforementioned plurality of nozzles and the aforementioned substrate can be controlled by the aforementioned movement mechanism.

In the aforementioned first film formation apparatus and second film formation apparatus, examples of the control of the relative positions of the aforementioned (plurality of) nozzles and the aforementioned substrate include, for example, to relatively control the position of the aforementioned nozzle and the position of the aforementioned substrate in the horizontal direction. According to this, the film can be formed selectively at a desired position of the aforementioned substrate. Furthermore, the area of the region to be provided with the film can be set appropriately by controlling the distance between the aforementioned nozzle and the aforementioned substrate. In particular, in the case where the material becomes a molecular beam or in the condition of supersonic molecular effusion when being discharged from the nozzle, the spatial expansion of the material has an especially strong positive correlation with the nozzle diameter, and has an especially strong positive correlation with the distance from the nozzle. Consequently, when the nozzle diameter is constant, the area of formation of the film can be determined with precision to some extent by controlling the distance between the nozzle and the substrate.

In the aforementioned method for manufacturing an electro-optic apparatus, preferably, a material for forming at least one of an electron transport layer, positive hole transport layer, luminescent layer, and electrode constituting an organic electroluminescent element is discharged as a material so as to pattern the electron transport layer, positive hole transport layer, luminescent layer, or electrode.

According to this, the material for forming the electron transport layer, positive hole transport layer, luminescent layer, or electrode can be selected with a high degree of flexibility. When the electron transport layer, positive hole transport layer, luminescent layer, or electrode is formed without the use of any solvent, the quantity of contamination of impurities from a solvent, etc., can be reduced. Consequently, extension of the life of the resulting element can be achieved.

In the aforementioned method for manufacturing an electro-optic apparatus, preferably, a partition wall for separating pixels from each other is formed beforehand on the aforementioned substrate, and the aforementioned material for formation is discharged inside the partition wall so as to pattern the electron transport layer, positive hole transport layer, or luminescent layer.

According to this, when the material for formation is discharged, even if there are variations to some extent in the positions of hitting thereof, the luminescent layer, etc., can be formed at desired positions as long as the positions of hitting are inside the partition wall. Consequently, by forming the pixels composed of the luminescent layer, etc., at respective desired positions, the display quality can be improved.

An electro-optic apparatus of the present invention is produced by the aforementioned method for manufacturing an electro-optic apparatus.

According to this electro-optic apparatus, since each of low-molecular-based materials and macromolecular-based materials is patterned without particular restriction as described above and, therefore, at least a part of the constituents thereof is formed, the degree of flexibility in selection of the material is increased in manufacture.

Electronic equipment of the present invention is provided with the aforementioned electro-optic apparatus as a display device.

In this electronic equipment as well, especially regarding the display device thereof, the degree of flexibility in selection of the material is increased in manufacture as described above.

An electronic apparatus of the present invention is manufactured using the aforementioned patterning apparatus.

Since this electronic apparatus is manufactured using the aforementioned patterning apparatus, regarding the patterning thereof, each of low-molecular-based materials and macromolecular-based materials can be selected without particular restriction.

### Brief Description of the Drawings

Fig. 1 is a side view showing the schematic configuration of an example of a patterning apparatus of the present invention.
Fig. 2 is a circuit diagram showing the arrangement portion of an electro-optic apparatus of the present invention.
Fig. 3 is a plan view showing a two-dimensional structure of the pixel portion in the electro-optic apparatus shown in Fig. 2 under magnification.
Figs. 4(a) to (e) are sectional views of the key portion side for illustrating step by step a method for manufacturing the electro-optic apparatus shown in Fig. 2 and Fig. 3.
Figs. 5(a) to (c) are sectional views of the key portion side for sequentially illustrating steps following Fig. 4.
Figs. 6(a) to (c) are sectional views of the key portion side for sequentially illustrating steps following Fig. 5.
Fig. 7 is a diagram schematically showing a connection example of a plurality of nozzles and a material supply source.
Fig. 8 is a diagram schematically showing configuration examples of discharge heads provided with a plurality of nozzles.
Fig. 9 is a diagram for illustrating another example of the electro-optic apparatus of the present invention, (a) is a plan view of the key portion, and (b) is a sectional view of the section indicated by a line B-B shown in (a).
Fig. 10 is a diagram showing specific examples of electronic equipment provided with an electroluminescent display, and (a) is a perspective view showing an example of application to a cellular phone, (b) is a perspective view showing an example of application to an information processing apparatus, and (c) is a perspective view showing an example of application to a wristwatch type electronic equipment.

### [Reference Numerals]

- 1:: patterning apparatus
- 2:: vacuum chamber
- 3:: nozzle
- 3a:: nozzle hole
- 4:: substrate stage
- 6:: vacuum apparatus
- 7:: material supply chamber (material supply source)
- 8:: carrier gas supply source
- 9:: heating device
- 10:: discharge mechanism
- 11:: movement mechanism
- 20:: display device
- 121:: transparent substrate
- 140A:: positive hole transport layer
- 140B:: luminescent layer
- 140C:: electron transport layer

### Description of the Embodiments

The present invention will be described below in detail.

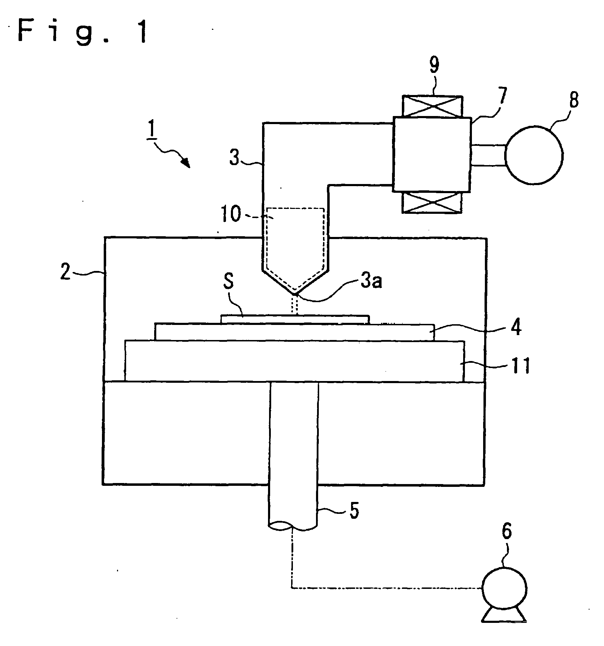

Fig. 1 is a diagram showing the schematic configuration of a patterning apparatus of the present invention. In Fig. 1, reference numeral 1 denotes the patterning apparatus. This patterning apparatus 1 is also an example of a film formation apparatus in the present invention. This patterning apparatus 1 is provided with a vacuum chamber 2, a nozzle 3 attached to this vacuum chamber 2, and a substrate stage 4 arranged in the vacuum chamber 2.

The vacuum chamber 2 is connected to a vacuum apparatus 6 through a piping 5, and in the inside space thereof, the substrate stage 4 is arranged, and a door (not shown in the drawing) for taking a substrate S targeted for patterning in and out is arranged airtight. The end portion of the piping 5 is open inside the vacuum chamber 2 and, thereby, the inside of the vacuum chamber 2 can be evacuated so as to bring about a high-vacuum atmosphere by the action of the vacuum apparatus described later.

The vacuum apparatus 6 is configured to become capable of adjusting the inside of the vacuum chamber 2 at a high degree of vacuum by the combination of a turbo-molecular pump, rotary pump, etc. The inside of the vacuum chamber 2 is adjusted at a high vacuum atmosphere of preferably 10⁻³ torr (1.33322 x 10 Pa) or less, and more preferably, 10⁻⁵ torr (1.33322 x 10⁻³ Pa) or less by the vacuum apparatus 6. When the vacuum atmosphere is specified to be 10⁻³ torr or less, for example, even materials unlikely to discharge can be discharged with ease, and when specified to be 10⁻⁵ torr or less, still more sorts of materials can be discharged and, in addition, the materials discharged can be vaporized so as to become likely to take the shape of a molecular beam. Regarding this vacuum apparatus 6, in order that the vibration of the pumps constituting this apparatus does not propagate inside the vacuum chamber 2, preferably, these pumps are arranged at an adequate distance from the vacuum chamber 2, or the pumps, etc., are imparted with a vibration isolation function.

Regarding the nozzle 3, the tip side provided with a nozzle hole 3a is arranged in the vacuum chamber 2, the rear end side thereof is connected outside the vacuum chamber 2 to a material supply chamber 7 as a material supply source and, in addition, a carrier gas supply source 8 is connected to this material supply chamber 7. The material supply chamber 7 is to store and hold patterning materials, and, for example, stores materials for forming a luminescent layer, electron transport layer, positive hole transport layer, etc., of an organic electroluminescent element in the condition of being held with a holder (not shown in the drawing), for example, a cell and crucible. This material supply chamber 7 is provided with a heating device 9 to heat the materials for formation held in the aforementioned holder so as to liquefy or vaporize this. As the heating device 9, for example, general electric heaters, lasers, e.g., a YAG laser, nitrogen laser, excimer laser, and titanium sapphire laser, and high frequency heating apparatuses, can be adopted, and are selected appropriately in accordance with the material, that is, in accordance with the degree of tendency of vaporization, for example, depending on liquid or solid at room temperature and the degree of the boiling point.

The carrier gas supply source 8 feeds primarily an inert gas, for example, helium, argon, and nitrogen, as a carrier gas to the material supply chamber 7 by pressure. Regarding some materials, a reactive gas which reacts with the material may be fed to the material supply chamber 7 as the carrier gas by pressure. The carrier gas fed to the material supply chamber 7 by pressure is accompanied with the material liquefied or vaporized in the material supply chamber 7 to a discharge mechanism side described later. Preparation of the material in the material supply chamber 7, that is, preparation for bringing the material into the liquid state or gaseous state, is selected appropriately based on the relationship with the discharge mechanism of the nozzle 3 described later, and the degree of heating by the aforementioned heating device 9, etc., are determined. The material may be discharged into the vacuum chamber 2 without the use of the carrier gas from the carrier gas supply source 8 although depending on the discharge mechanism of the nozzle 3.

The tip portion of the nozzle 3 is provided with the discharge mechanism 10. Various types of discharge mechanisms 10 can be used without particular restriction. For example, mechanisms by common mechanical shutters, continuous system mechanisms of charge control type, pressure vibration type, etc., and on-demand system mechanisms of electromechanical type (so-called piezo-type), electrothermal type, electrostatic attraction type, etc., can be adopted.

In the mechanism by the mechanical shutter, for example, the nozzle hole 3a is provided with a shutter (not shown in the drawing), this is mechanically opened and closed and, therefore, the material fed by pressure while accompanying the carrier gas is discharged intermittently (pulse-like). This mechanism may be configured to discharge spontaneously the material in the nozzle 3 from the nozzle hole 3a depending on the pressure difference between the pressure in the vacuum chamber 2 which is outside the nozzle hole 3a and the pressure in the nozzle 3, accompanying open and close of the shutter without the use of the carrier gas. The mechanical shutter may be arranged at a proper position in a route from the material supply chamber 7 to the nozzle hole 3a, and be arranged on the outlet side of the material supply chamber 7.

Regarding the charge control type, the material fed is charged by a charge electrode, and is discharged from the nozzle hole 3a while the flying direction of the material is controlled by a deflection electrode. Regarding the pressure vibration type, the material is discharged to the nozzle tip side by application of an extra-high pressure on the order of 30 kg/cm2 to the material. When the control voltage is not applied, the material moves straight ahead and is discharged through the nozzle hole 3a, and when the control voltage is applied, electrostatic repulsion occurs between the materials and, therefore, the material flies and does not pass through the nozzle 3a.

The electromechanical type uses the property of a piezoelectric element to become deformed by application of a pulse-like electric signal. A pressure is applied to a space storing the material by deformation of the piezoelectric element via a pliable substance and, therefore, the material is extruded from this space and is discharged from the nozzle 3a. Regarding the space which stores the material, for example, a minute material storage space communicating to the internal space of the material supply chamber 7 may be formed.

Regarding the electrothermal type, in general, the material is vaporized rapidly by a heater arranged in the space storing the material so as to generate a bubble (foam), and the material in the space is discharged by the pressure of the bubble. In the present invention, this can be used as a heating device.

Regarding the electrostatic attraction type, a very small pressure is applied to the space storing the material so as to form a meniscus of the material in the nozzle, and under this condition, electrostatic attraction is applied so as to pull out the material.

Each of these mechanisms of the charge control type, pressure vibration type, electromechanical type, electrothermal type, and electrostatic attraction type may be used concurrently with the aforementioned mechanism by the mechanical shutter and, therefore, discharge control of the material may be performed with reliability, or intermittent discharge may be performed with reliability.

When the carrier gas is used, by controlling feeding of the carrier gas, intermittent discharge may be performed.

The substrate stage 4 is arranged directly below the aforementioned nozzle hole 3a, and is to hold and fix the substrate S for manufacturing an electro-optic apparatus composed of an organic electroluminescent element, etc., for example, as described later. This substrate stage 4 is provided with a movement mechanism 11 which can move the substrate S held and fixed in the X direction, Y direction, and Z direction relative to the aforementioned nozzle hole 3a. That is, this movement mechanism 11 is provided with a Z movement portion (not shown in the drawing), which can move and position the substrate S in the vertical direction (Z direction) relative to the nozzle hole 3a so as to adjust the distance between the substrate S and the nozzle hole 3a, and X movement portion (not shown in the drawing) and Y movement portion (not shown in the drawing), which move and position the substrate stage 4 in the horizontal direction (X direction and Y direction), respectively, relative to the nozzle hole 3a, and is configured to be able to control the individual actions of these movement portions in accordance with settings set by a control portion (not shown in the drawing). These X movement portion, Y movement portion, and Z movement portion are composed of, for example, linear motors.

This substrate stage 4 is provided with a temperature adjustment device (not shown in the drawing) of water cooling type and the like on the mounting surface side thereof and, thereby, the substrate S on the substrate stage 4 can be adjusted at a desired temperature.

Next, an example will be described, in which patterning by the patterning apparatus 1 having such a configuration is applied to manufacture of an electro-optic apparatus. The patterning by the patterning apparatus 1 here can be also an example of a method for manufacturing a film by a film formation apparatus of the present invention.

Initially, a rough configuration of an electro-optic apparatus produced by this manufacture will be described.

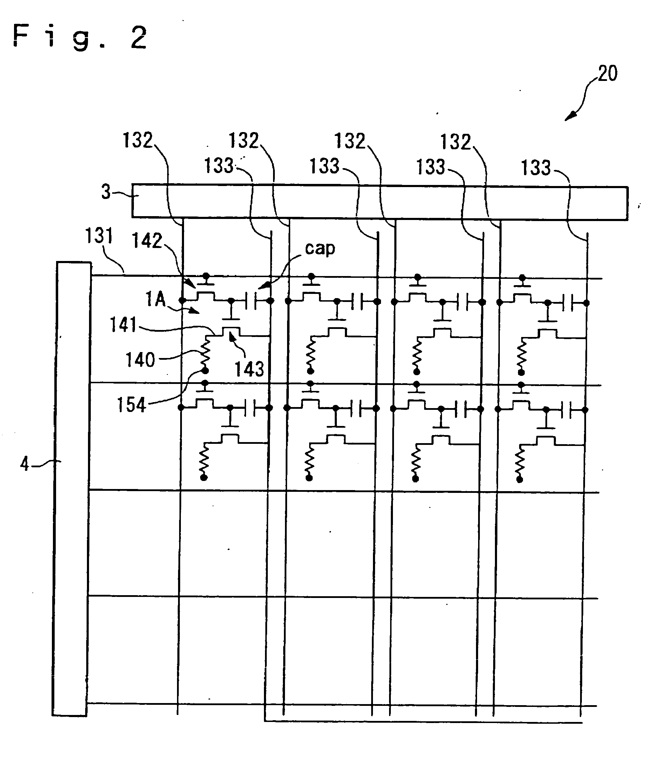

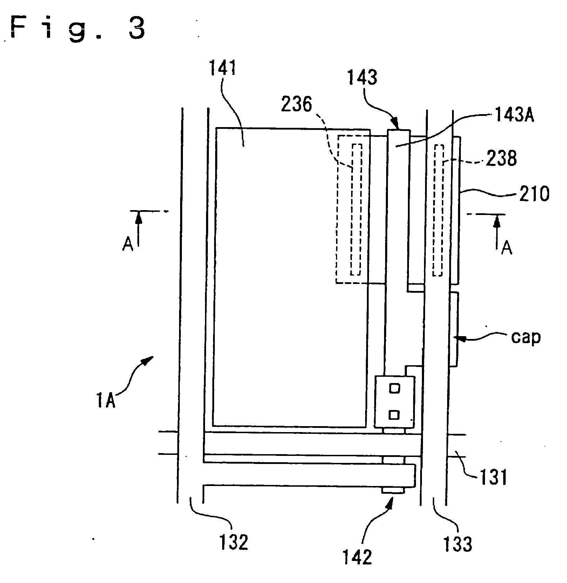

Fig. 2 and Fig. 3 show an example in which the electro-optic apparatus according to the present invention is applied to a display device of active matrix type using an organic electroluminescent element, and in these drawings, reference numeral 20 denotes the display device. In this example, especially, an example in which a material for forming a luminescent layer as an optical material and the like are arranged by the aforementioned patterning apparatus 1 using a scanning line, signal line, and common feeder line as wirings is shown.

As shown in a circuit diagram, Fig. 2, this display device 20 has a configuration in which respective wirings of a plurality of scanning lines 131, a plurality of signal lines 132 extending in the direction intersecting these scanning lines 131, and common feeder lines 133 extending parallel to these signal lines 132 are arranged on a transparent substrate, and pixels (pixel region elements) 1A are arranged on an intersection of the scanning line 131 and the signal line 132 basis.

With respect to the signal lines 132, a data side driving circuit 3 provided with a shift resister, level shifter, video line, and analog switch are arranged.

On the other hand, with respect to the scanning lines 131, a scanning side driving circuit 4 provided with a shift resister and level shifter is arranged. In each of the pixel regions 1A, a first thin film transistor 142 in which scanning signals are supplied to a gate electrode through the scanning line 131, a retention volume cap which retains image signals supplied from the signal line 132 through this first thin film transistor 142, a second thin film transistor 143 in which the image signals retained by the retention volume cap are supplied to a gate electrode, a pixel electrode 141 into which driving current is fed from the common feeder line 133 when electrically connected to the common feeder line 133 through this second thin film transistor 143, and a luminescent portion 140 held between this pixel electrode 141 and a counter electrode 154 are arranged.

Under such a configuration, when the scanning line 131 is driven and the first thin film transistor 142 is turned on, the voltage of the signal line 132 at that time is retained by the retention volume cap, and the conduction condition of the second thin film transistor 143 is determined in accordance with the condition of the retention volume cap. Subsequently, a current passes from the common feeder line 133 to the pixel electrode 141 through the channel of the second thin film transistor 143 and furthermore, a current passes to the counter electrode 154 through the luminescent element 140. Consequently, the luminescent portion 140 emits light in accordance with the quantity of the current passing thereto.

As shown in Fig. 3 which is a plan view under magnification in the condition that the counter electrode and the organic electroluminescent element are removed, the two-dimensional structure of each pixel 1A has an arrangement in which four sides of the pixel electrode 141 in a rectangular two-dimensional shape are surrounded by the signal line 132, common feeder line 133, scanning line 131, and a scanning line for other pixel electrode, although not shown in the drawing.

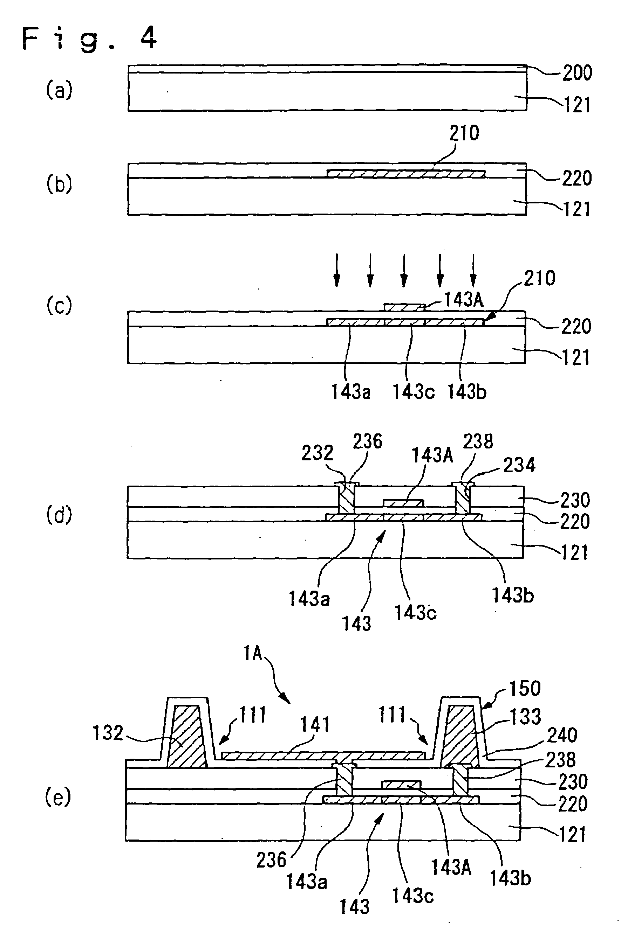

Next, a method for manufacturing an organic electroluminescent element used for such a display device 20 will be described with reference to Fig. 4 to Fig. 6. In Fig. 4 to Fig. 6, only a single pixel 1A is illustrated in order to simplify the description.

A substrate is prepared. Regarding the organic electroluminescent element, emitted light by a luminescent layer described later can be taken out from the substrate side, and can also be configured to take out from the side opposite to the substrate. Regarding the configuration in which the emitted light is taken out from the substrate side, as the material for the substrate, transparent or translucent materials, for example, glass, quartz, and resin, are used, however, especially inexpensive soda glass is used suitably. When the soda glass is used, preferably, a silica coat is applied thereto because an effect of protecting soda glass susceptible to the acid or alkali is exerted and, in addition, an effect of improving the flatness of the substrate is also exerted.

The emission color may be controlled by placing a color conversion film including a color filter film or a luminescent material or a dielectric reflection film on the substrate.

Regarding the configuration in which the emitted light is taken out from the side opposite to the substrate, the substrate may be opaque, and in that case, ceramics, for example, alumina, metal sheets of stainless steel, etc., subjected to an insulation treatment, for example, surface oxidation, thermosetting resins, thermoplastic resins, and the like can be used.

In this example, as shown in Fig. 4(a), a transparent substrate 121 made of soda glass, etc., is prepared as a substrate. With respect to this, if necessary, a substrate protection film (not shown in the drawing) made of silicon oxide film of about 200 to 500 nm in thickness is formed by a plasma CVD method using TEOS (tetraethoxysilane), oxygen gas, etc., as materials.

The temperature of the transparent substrate 121 is set at about 350°C, and a semiconductor film 200 made of an amorphous silicon film of about 30 to 70 nm in thickness is formed by a plasma CVD method on the surface of the substrate protection film. Subsequently, a crystallization step of a laser annealing method, solid phase growth method, or the like is performed with respect to this semiconductor film 200 and, therefore, the semiconductor film 200 is crystallized to a polysilicon film. In the laser annealing method, for example, a line beam of 400 mm in major axis from an excimer laser is used, and the output intensity thereof is specified to be, for example, 200 mJ/cm2. Regarding the line beam, the line beam is scanned in order that the portions corresponding to 90% of the peak value of the laser intensity in the minor axis direction overlap on a region basis.

As shown in Fig. 4(b), the semiconductor film (polysilicon film) 200 is patterned so as to produce an island-shaped semiconductor film 210, and with respect to the surface thereof, a gate insulation film 220 made of a silicon oxide film or nitride film of about 60 to 150 nm in thickness is formed by a plasma CVD method using TEOS, oxygen gas, etc., as materials. The semiconductor film 210 is to become a channel region and a source and drain region of the second thin film transistor 143 shown in Fig. 2, and at different sectional positions, a semiconductor film to become a channel region and a source and drain region of the first thin film transistor 142 is also formed. That is, in the manufacturing steps shown in Fig. 4 to Fig. 6, two sorts of transistors 142 and 143 are produced simultaneously. However, since the manufacturing procedures are the same, in the following description, regarding the transistors, only the second thin film transistor 143 will be explained, and the explanation of the first thin film transistor 142 is omitted.

As shown in Fig. 4(c), a conductive film containing metals, for example, aluminum, tantalum, molybdenum, titanium, and tungsten, is formed by a sputtering method and, thereafter, this is patterned so as to form a gate electrode 143A.

Under this condition, phosphorus ions are implanted at a high concentration and, therefore, source and drain regions 143a and 143b are formed in the semiconductor film 210 based on self align with respect to the gate electrode 143A. The portion into which no impurity has been introduced becomes a channel region 143c.

As shown in Fig. 4(d), after an interlayer insulation film 230 is formed, contact holes 232 and 234 are formed, and relay electrodes 236 and 238 are embedded in those contact holes 232 and 234.

As shown in Fig. 4(e), the signal line 132, common feeder line 133, and scanning lines (not shown in Fig. 4) are formed on the interlayer insulation film 230. At this time, regardless of the thickness required as wirings, each wiring of the signal line 132, common feeder line 133, and scanning lines is formed to have an adequate thickness in order to allow these to function as a partition wall as described later. Specifically, each wiring is formed to have a thickness on the order of 1 to 2 µm. The relay electrode 238 and each wiring may be formed in the same step. At this time, the relay electrode 236 is formed from an ITO film described later.

An interlayer insulation film 240 is formed covering the top surface of each wiring as well, and a contact hole (not shown in the drawing) is formed at the position corresponding to the relay electrode 236. A film composed of SnO₂ doped with ITO or fluorine, and furthermore, a transparent electrode material, for example, ZnO and polyaniline is formed while being embedded in the contact hole as well. Subsequently, this film is patterned and, therefore, the pixel electrode 141 is formed at a predetermined position surrounded by the signal line 132, common feeder line 133, and scanning lines (not shown in the drawing) while being electrically connected to the source and drain region 143a.

The portion surrounded by the signal line 132, common feeder line 133, and scanning lines (not shown in the drawing) is the formation site of the positive hole transport layer and the luminescent layer as described later. That is, a partition wall 150 which separates pixels 1A from each other is formed from these wirings and the interlayer insulation film 240 covering this. Under such a configuration, an adequate height difference 111 is formed between the formation site of the positive hole transport layer and luminescent layer, that is, the arrangement (ejection) position of the materials for forming them, and the partition wall 150 on the periphery thereof.

After the partition wall 150 composed of those wirings is formed as described above, this substrate 121 is put into the vacuum chamber 2 shown in Fig. 1, is placed on the substrate stage 4 in the condition that the top surface side is facing upward, and is held and fixed here. If necessary, the substrate 121 on the substrate stage 4 is adjusted at a desired temperature, that is, a temperature at which the material for formation ejected from the nozzle hole 3a in the condition of, for example, being vaporized is cooled adequately and, therefore, can be liquefied or solidified, by a temperature control device (not shown in the drawing). The material for forming the positive hole transport layer, the material being held beforehand by the holder in the material supply chamber 7, is heated by the heating device 9 to a predetermined temperature.

The material for forming the positive hole transport layer is not specifically limited, and those publicly known can be used. Examples thereof include, for example, pyrazoline derivatives, arylamine derivatives, stilbene derivatives, and triphenyldiamine derivatives. Specific examples include, for example, those described in Japanese Unexamined Patent Application Publication No. 63-70257, Japanese Unexamined Patent Application Publication No. 63-175860, Japanese Unexamined Patent Application Publication No. 2-135359, Japanese Unexamined Patent Application Publication No. 2-135361, Japanese Unexamined Patent Application Publication No. 2-209988, Japanese Unexamined Patent Application Publication No. 3-37992, and Japanese Unexamined Patent Application Publication No. 3-152184. However, the triphenyldiamine derivatives are preferable, and among them, 4,4'-bis(N(3-methylphenyl)-N-phenylamino)biphenyl is considered to be suitable.

A positive hole injection layer may be formed instead of the positive hole transport layer, and furthermore, both of the positive hole injection layer and the positive hole transport layer may be formed. At that time, examples of materials for forming the positive hole injection layer include, for example, copper phthalocyanine (CuPc), polyphenylene vinylene that is polytetrahydrothiophenylphenylene, 1,1-bis-(4-N,N-ditolylaminophenyl)cyclohexane, and tris(8-hydroxyquinolinol) aluminum, and in particular, copper phthalocyanine (CuPc) is used preferably.

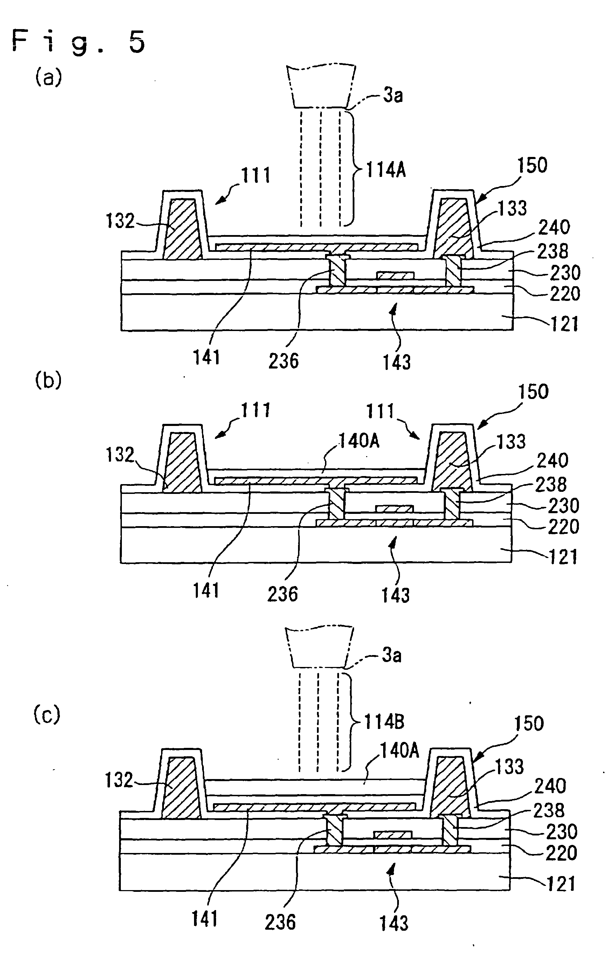

After such a material for formation is heated by the heating device 9 to a predetermined temperature as described above, the carrier gas, for example, helium, is introduced from the carrier gas supply source 8 into the material supply chamber 7 and, in addition, the aforementioned discharge mechanism 10 is actuated so as to discharge the material for formation from the nozzle hole 3a into the vacuum chamber 2 in the condition of accompanying the carrier gas. Since the material for formation is thereby discharged into the vacuum chamber 2 in an atmosphere at a pressure adequately lower than that in the nozzle 3, which is nearly atmospheric pressure, this material for formation is discharged in the condition of being vaporized as shown in Fig. 5(a). In an ideal case where the vacuum chamber 2 is at especially high degree of vacuum, the material for formation may be discharged in the shape of a molecular beam.

Consequently, when the action of the movement mechanism 11 is controlled by the control portion (not shown in the drawing) and, thereby, the relative positional relationship between the nozzle hole 3a and the substrate 121 is moved in accordance with the settings set beforehand, a desired quantity of this material 114A for formation can be ejected at a predetermined position, that is, the region of each pixel 1A surrounded by the partition wall 150, on the substrate 121. When the material for formation is ejected on the pixel 1A, this material for formation is cooled to the temperature of the substrate 121 and, therefore, is liquefied or solidified and is fixed here. At this time, in the case where the material 114A for formation discharged is liquefied on the substrate 121, although the material 114A for formation tends to spread in the horizontal direction because of the flowability thereof, since the partition wall 150 is arranged surrounding the position of ejection, the material 114A for formation is prevented from spreading over the partition wall 150 to the outside thereof.

When the material 114A for formation discharged is liquefied on the substrate 121 as described above, the substrate 121 may be taken out of the vacuum chamber 2 on a temporary basis and, if necessary, a treatment of heating, light irradiation, or the like may be performed so as to form the solid positive hole transport layer 140A on the pixel electrode 141 as shown in Fig. 5(b). In the case where the material 114A for formation discharged is solidified on the substrate 121, the aforementioned treatment is not performed and, therefore, formation of the luminescent layer is performed succeedingly.

A positive hole injection layer may be formed using the aforementioned copper phthalocyanine (CuPc), etc., instead of formation of the positive hole transport layer 140A described above. In particular, preferably, the positive hole injection layer is formed on the pixel electrode 141 side in advance of formation of the positive hole transport layer 140A, and furthermore, the positive hole transport layer 140A is formed. By forming the positive hole injection layer together with the positive hole transport layer 140A, an increase of the driving voltage can be controlled and, in addition, the driving life (half-life) can be extended as well.

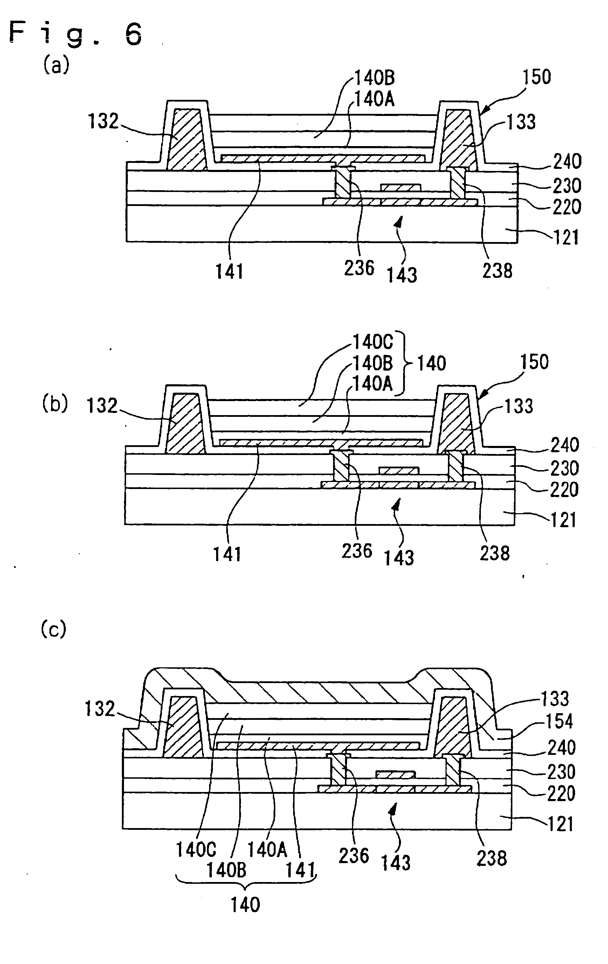

Subsequently, in a manner similar to that in the material for forming the aforementioned positive hole transport layer (and/or positive hole injection layer), as shown in Fig. 5(c), a material 114B for forming a luminescent layer is discharged (ejected) on the substrate 121 by the patterning apparatus 1 and, thereby, a luminescent layer 140B is formed as shown in Fig. 6(a). The material 114B for forming the luminescent layer is not specifically limited, and low-molecular organic luminescent coloring matters and macromolecular luminescent materials, that is, various luminescent substances made of fluorophors or phosphors, can be used. Among conjugate macromolecules to become luminescent substances, those having an arylene vinylene structure are especially preferable. Examples of usable low-molecular luminophors include, for example, naphthalene derivatives, anthracene derivatives, perylene derivatives, coloring matters of polymethine-base, xanthene-base, coumarin-base, cyanine-base, etc., metal complexes of 8-hydroquinoline and derivatives thereof, aromatic amines, tetraphenylcyclopentadiene derivatives, and publicly known materials described in Japanese Unexamined Patent Application Publication No. 57-51781, Japanese Unexamined Patent Application Publication No. 59-194393, etc.

When the macromolecular luminescent materials are used as the material for forming the luminescent layer, macromolecules having a luminescent group in a side chain can be used, and those having a conjugate structure in the main chain are preferable. In particular, polythiophene, poly-p-phenylene, polyarylene vinylene, polyfluorene, and polythiophene, poly-p-phenylene, polyarylene vinylene, polyfluorene, and derivatives thereof are preferable. Among them, polyarylene vinylene and derivatives thereof are preferable. The polyarylene vinylene and derivatives thereof are polymers containing a repeating unit which is represented by the following Chemical formula (1) and which constitutes 50% by mole or more of the total repeating units. More preferably, the repeating unit represented by Chemical formula (1) constitutes 70% by mole or more of the total repeating units although it depends on the structure of the repeating unit.

-Ar-CR=CR'- (1)

[where Ar denotes an arylene group or heterocyclic compound group, each having the number of carbon atoms involving in conjugated bonds of 4 or more, but 20 or less, and R and R' denote independently a group selected from the group consisting of hydrogen, alkyl groups having the carbon number of 1 to 20, aryl groups having the carbon number of 6 to 20, heterocyclic compounds having the carbon number of 4 to 20, and a cyano group. ]

The macromolecular luminescent materials may include aromatic compound groups or derivatives thereof, heterocyclic compounds or derivatives thereof, groups produced by combination thereof, and the like as repeating units other than the repeating unit represented by Chemical formula (1). Furthermore, the repeating units represented by Chemical formula (1) or other repeating units may be joined by a nonconjugated unit having an ether group, ester group, amide group, imide group, etc., and those nonconjugated parts may be contained in the

Examples of polyarylene vinylene include, for example, PPV derivatives represented by Chemical formula (2), e.g., PPV (poly(para-phenylene vinylene)), MO-PPV (poly(2,5-dimethoxy-1,4-phenylene vinylene)), CN-PPV (poly(2,5-bishexyloxy-1,4-phenylene-(1-cyanovinylene))), and MEH-PPV (poly[2-methoxy-5-(2'-ethylhexyloxy)]-para-phenylene vinylene).

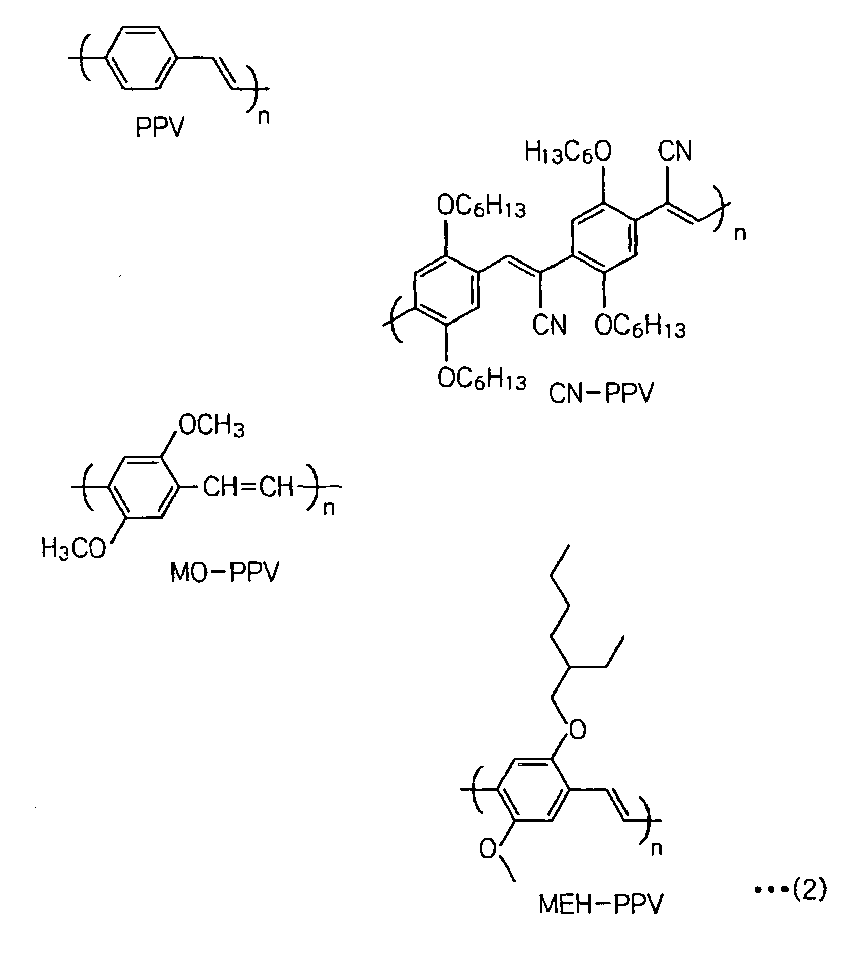

In addition to the aforementioned materials, poly(para-phenylene) and polyalkylfluorene, for example, are mentioned, and polyalkylfluorene represented by Chemical formula (3) (specifically, polyalkylfluorene-based copolymer represented by Chemical formula (4)) are especially preferable. 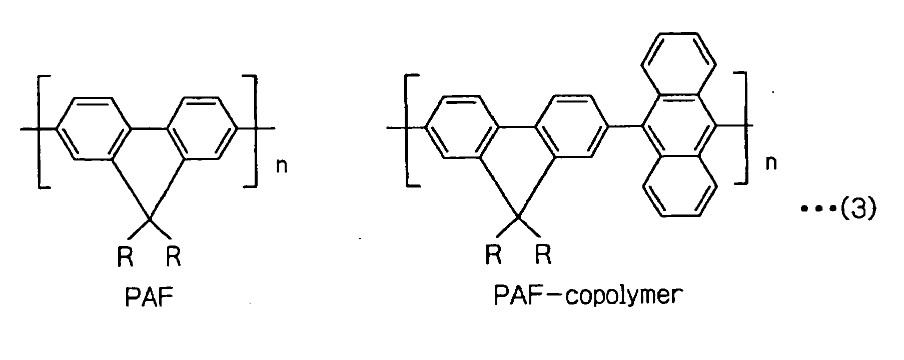 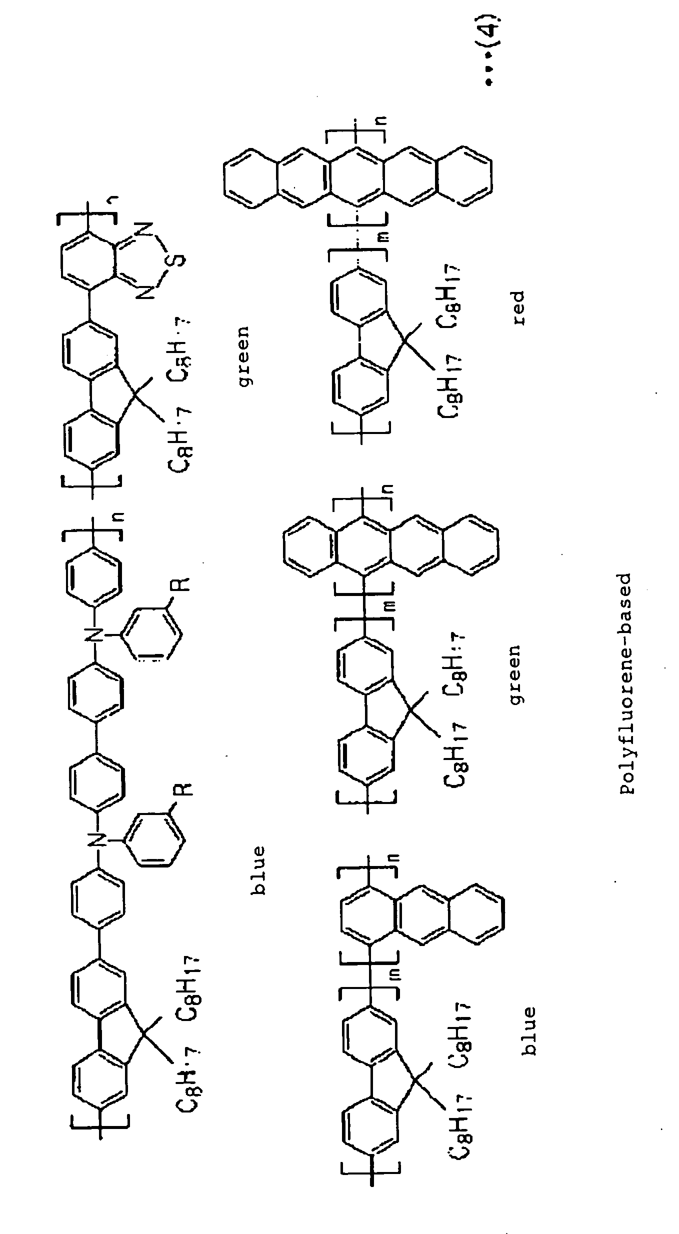 The aforementioned macromolecular luminescent material may be a random, block, or graft copolymer, or may be a macromolecule having an intermediate structure between them, for example, a random copolymer taking on properties of block. The random copolymer taking on properties of block, or the block or graft copolymer is preferable compared with a completely random copolymer from the viewpoint of production of a macromolecular luminescent material having a high quantum yield of emission. Since the organic EL element formed here uses emission from a thin film, the macromolecular luminescent material having an excellent emission quantum yield in solid state is used.

Among the aforementioned materials, materials which are liquid at a temperature during formation of the luminescent layer or materials exhibiting excellent solubility with respect to a desired solvent can be used for forming the luminescent layer by the use of a liquid material, for example, an ink-jet method. As the solvent, for example, chloroform, methylene chloride, dichloroethane, tetrahydrofuran, toluene, and xylene, are used suitably. In general, 0.1% by weight or more of macromolecular luminescent material can be dissolved in these solvents although it depends on the structure and molecular weight thereof.

The aforementioned macromolecular luminescent materials may preferably have a molecular weight of 10³ to 10⁷ in terms of polystyrene. However, oligomers having a molecular weight of 10³ or less can also be used.

Here, the method for patterning or method for forming a film of the present invention can also be used instead of the ink-jet method.

A desired macromolecular luminescent material can be produced by adopting a method for synthesis in accordance with the desired macromolecular luminescent material. For example, Wittig reaction of a dialdehyde compound in which two aldehyde groups are bonded to an arylene group and a diphosphonium salt produced from a compound in which two halogenated methyl groups are bonded to an arylene group and triphenylphosphine is exemplified. As another method for synthesis, a method for dehydrohalogenation of a compound in which two halogenated methyl groups are bonded to an arylene group is exemplified. Furthermore, a sulfonium salt decomposition method in which the macromolecular luminescent material is produced by a heat treatment of an intermediate obtained from polymerization of a sulfonium salt of the compound in which two halogenated methyl groups are bonded to an arylene group using an alkali is exemplified.

More specifically, a method for synthesizing an arylene vinylene-based copolymer as an example of the aforementioned macromolecular luminescent material will be described. For example, when the macromolecular luminescent material is produced by the Wittig reaction, for example, a bis(halogenated methyl) compound, more specifically, 2,5-dioctyloxy-p-xylylenedibromide, for example, is reacted with triphenylphosphine in a N,N-dimethylformamide solvent and, therefore, a phosphonium salt is synthesized. This and a dialdehyde compound, more specifically, terephthalaldehyde, for example, are condensed in ethyl alcohol, for example, by the Wittig reaction using lithium ethoxide and, therefore, a macromolecular luminescent material containing a phenylene vinylene group and a 2,5-dioctyloxy-p-phenylene vinylene group is produced. At.this time, in order to produce a copolymer, two sorts or more of diphosphonium salts and/or two sorts or more of dialdehyde compounds may be reacted.

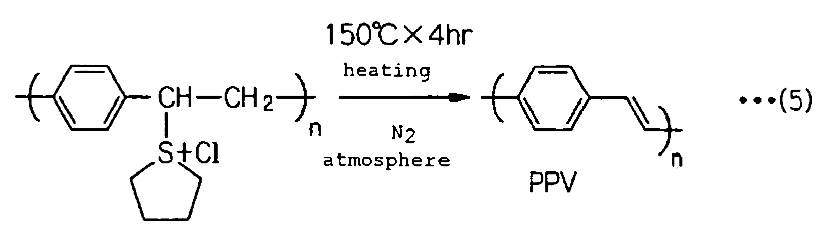

When these macromolecular luminescent materials are used as the materials for forming a luminescent layer, since the purity thereof affects the emission property, after synthesis is performed, desirably, a purification treatment, for example, refining by reprecipitation, fractionation by chromatograph, etc., is performed. When the macromolecular material is a material having low solubility, for example, some materials can produce the luminescent layer by applying a coating of a precursor corresponding thereto and, thereafter, performing curing with heat as shown in Chemical formula (5). For example, when polyphenylene-vinylene is the macromolecular luminescent material constituting the luminescent layer, after a sulfonium salt of a precursor corresponding thereto is placed at the portion to become the luminescent layer, a heat treatment is performed so as to remove the sulfonium group and, therefore, polyphenylene-vinylene (PPV) can be produced. When such a material is used for the present invention, the aforementioned precursor may be patterned by the method for patterning or method for forming a film of the present invention and, thereafter, a heat treatment may be performed so as to produce polyphenylene-vinylene, or polyphenylene-vinylene produced by heat-treating the precursor may be patterned by the method for patterning or method for forming a film of the present invention.

That is, when various functional layers, for example, the luminescent layer, electron transport layer, and positive hole transport layer, are formed, materials constituting the functional layers can be patterned directly by the method for patterning or method for forming a film of the present invention, and materials to become the precursors of the functional layers can be patterned as well.

As the low-molecular material capable of forming the luminescent layer, any materials exhibiting emission in the visible region can be used basically. Most of all, the material having an aromatic substituent is suitable. Examples thereof include, for example, those conventionally commonly used, e.g., aluminum quinolinol complex (Alq3) and distyrylbiphenyl, BeBq₂ and Zn(OXZ)₂ represented by Chemical formula (6), and in addition to them, pyrazoline dimer, quinolidinecarboxylic acid, benzopyrylium perchlorate, benzopyranoquinolidine, rubrene, and phenanthroline europium complex.

When materials exhibiting blue, green, and red emission are selected appropriately from the macromolecular materials and low-molecular materials exemplified by the above description, and are arranged at predetermined positions, color display can be performed. Regarding the arrangement at the predetermined positions, although a mask evaporation method and a printing method can be adopted, more preferably, the method for patterning or method for forming a film of the present invention is used.

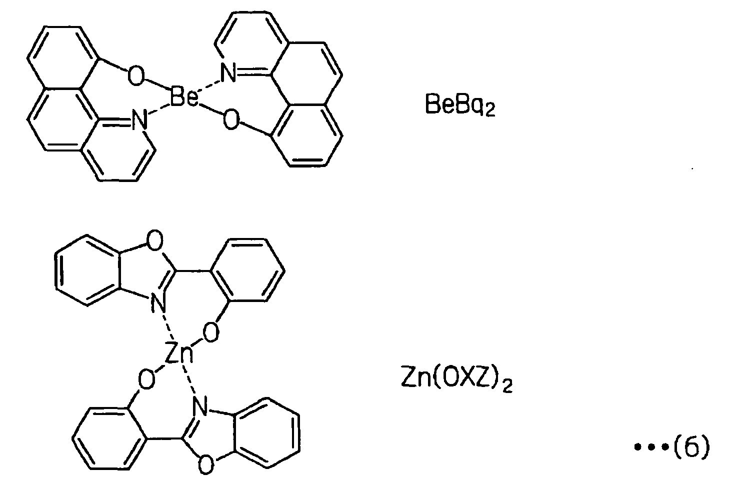

The luminescent layer may be a so-called host/guest type luminescent layer in which the host is dispersed in the guest functioning as a medium.

In the host/guest type luminescent layer, since the guest material determines basically the emission color of the luminescent layer, the guest material can be selected in accordance with a desired emission color. In general, materials which effectively perform emission are used. Regarding the host material, basically, the material having an energy level higher than the level in an excited state that involves to the emission of the guest material is suitable as the host material. The material may be required to have a high carrier mobility, and in that case, the material can also be selected from the aforementioned macromolecular luminescent materials.

Examples of guest materials exhibiting blue emission include, for example, coronenes and distyrylbiphenyls, examples of guest materials exhibiting green emission include, for example, quinacridones and rubrenes, and regarding guest materials exhibiting red emission, examples of fluorophors as guest materials exhibiting red emission include, for example, rhodamines. The host material can be selected appropriately in accordance with the guest material. For several examples, by forming a luminescent layer in which the host material and the guest material are Zn(OXZ)₂ and coronene, respectively, a luminescent layer exhibiting blue emission can be produced.

As the guest material, phosphors can also be used. For example, Ir(ppy)₃, Pt(thpy)₂, and PtOEP represented by Chemical formula (7) are used suitably.

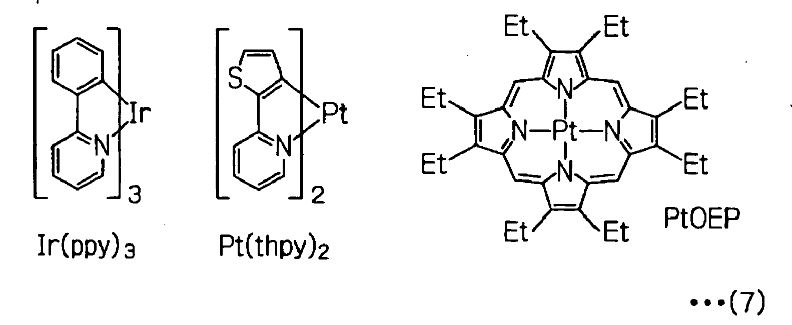

When the phosphors represented by the aforementioned Chemical formula (7) are guest materials, as host materials, for example, CBP, DCTA, or TCPB represented by Chemical formula (8), Alq3, or the like is used suitably.

When the method of the present invention is adopted, the host/guest type luminescent layer is formed by, for example, the following method.

Regarding a first method, a host/guest material of a predetermined mixing ratio is formed beforehand, and this is discharged from a nozzle hole.

Regarding a second method, the host material and the guest material are individually stored in different material supply chambers, and the quantities of flows of carrier gases to respective material supply chambers are set appropriately so as to adjust the ratio of the discharge quantities of the host material and the guest material, or valves arranged on the nozzle hole sides of the material supply chambers are adjusted so as to adjust the ratio of the quantities of the host material and the guest material to be discharged on the substrate, and under that condition, discharge is performed on the substrate.

Furthermore, a dope type luminescent layer in which a material for bringing about emission is added to a proper medium is also useful and, therefore, a material for forming such a dope type luminescent layer can be used as a matter of course.

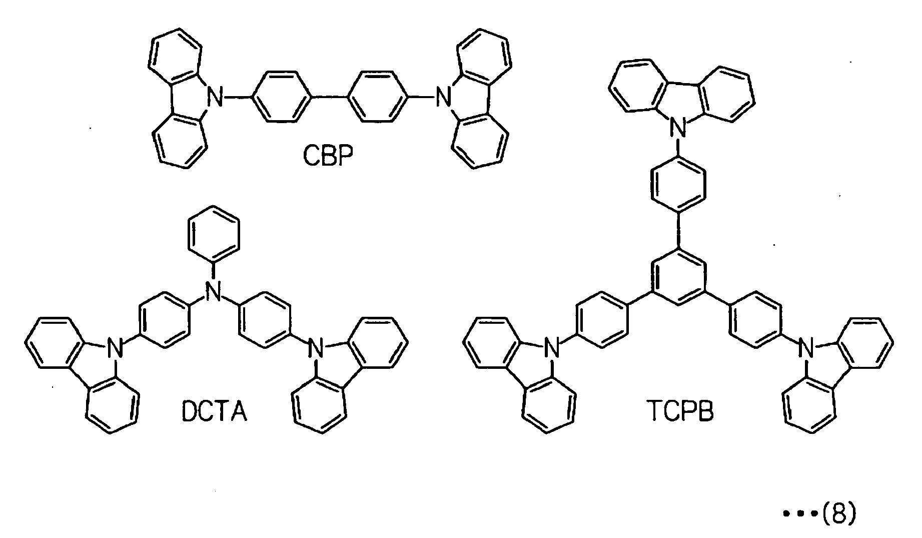

After the luminescent layer 140B is formed on the positive hole transport layer 140A of each pixel 1A as described above, in a manner similar to those in the positive hole transport layer 140A and the luminescent layer 140B, a material for forming an electron transport layer is discharged (ejected) on the substrate 121 by the patterning apparatus 1 and, thereby, the electron transport layer 140C is formed as shown in Fig. 6(b). The material for forming the electron transport layer is not specifically limited, and examples thereof include, for example, oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, and metal complexes of 8-hydroxyquinoline and derivatives thereof. Similarly to the materials for forming the aforementioned positive hole transport layer, specific examples include, for example, those described in Japanese Unexamined Patent Application Publication No. 63-70257, Japanese Unexamined Patent Application Publication No. 63-175860, Japanese Unexamined Patent Application Publication No. 2-135359, Japanese Unexamined Patent Application Publication No. 2-135361, Japanese Unexamined Patent Application Publication No. 2-209988, Japanese Unexamined Patent Application Publication No. 3-37992, and Japanese Unexamined Patent Application Publication No. 3-152184. In particular, 2-(4-biphenylyl)-5-(4-t-butylphenyl)-1,3,4-oxadiazole, benzoquinone, anthraquinone, and tris(8-quinolinol)aluminum are considered to be suitable.

The aforementioned materials for forming the positive hole transport layer 140A and the materials for forming the electron transport layer 140C may be mixed into the materials for forming the luminescent layer 140B, and may be used as the materials for forming the luminescent layer. In that case, although the usage of the materials for forming the positive hole transport layer and the materials for forming the electron transport layer varies depending on, for example, the sorts of the compounds used, the usage is determined appropriately within the range of the quantity that does not inhibit adequate film making property and emission property in consideration of them. In general, it is specified to be 1 to 40% by weight relative to the material for forming the luminescent layer, and further preferably, is specified to be 2 to 30% by weight. Regarding the film thicknesses of the positive hole transport layer 140A, luminescent layer 140B, and electron transport layer 140C thus formed, by setting appropriately the quantity of discharge from the nozzle hole 3a in advance, formation is performed to have preferable thicknesses (for example, 65 nm). The adjustment of the quantity of discharge can be performed by, for example, setting appropriately the inner diameter of the nozzle hole 3a and the quantity of flow of the carrier gas. The film thickness may be controlled to become an optimum thickness (appropriate thickness) by using a quartz type film thickness monitor, or by monitoring spectroscopic data, e.g., emission intensity and light absorption intensity.

Thereafter, as shown in Fig. 6(c), a counter electrode 154 is formed on all over the surface of the transparent electrode 121 or in the shape of stripes and, therefore, an organic electroluminescent element is produced. As a matter of course, such a counter electrode 154 may be formed from one layer made of a single material, for example, A1, Mg, Li, and Ca, or an alloy material of Mg : Ag (10:1 alloy). However, the counter electrode 154 may be formed as a metal (including alloy) layer made of two layers or three layers. Specifically, those having laminated structures, for example, Li₂O (on the order of 0.5 nm) / Al, LiF (on the order of 0.5 nm) / Al, and MgF₂ / Al, can also be used.

In the present example, both of the pixel electrode 141 and the counter electrode 154 are formed by the conventional method. However, these electrodes may also be formed by the patterning apparatus 1 of the present invention. That is, transparent electrodes (anodes), for example, indium tin oxide (ITO), tin oxide (SnO₂), and zinc oxide (ZnO), and cathodes composed of a laminated structure of Al/Ca, etc., can be formed by the patterning apparatus 1 of the present invention.

In addition to the aforementioned positive hole injection layer (not shown in the drawing), positive hole transport layer 140A, luminescent layer 140B, and electron transport layer 140C, a whole blocking layer may be formed, for example, on the counter electrode 154 side of the luminescent layer 140B in order to achieve extension of the life of the luminescent layer 140B. As the material for forming such a whole blocking layer, for example, BCP represented by Chemical formula (9) and BAlq represented by Chemical formula (10) are used. However, BAlq is more preferable from the viewpoint of extension of the life.

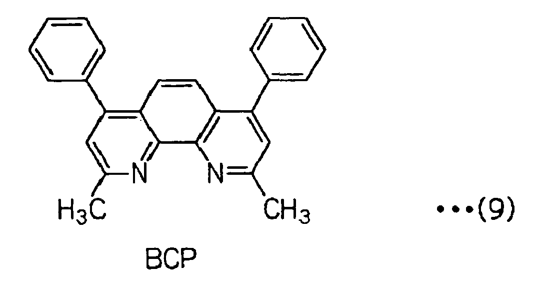

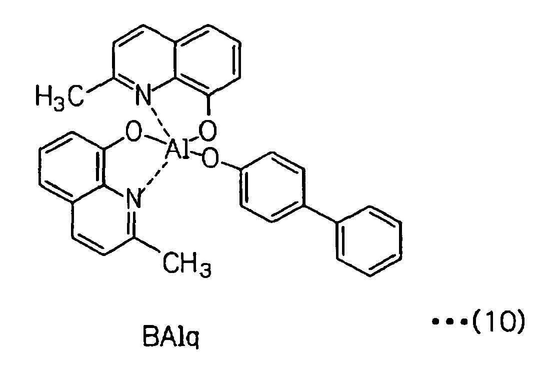

In the present example, each material is discharged into the vacuum chamber 2 in the condition of being vaporized. However, by adjusting the degree of vacuum in the vacuum chamber 2, the degree of heating by the heating device 9, etc., the material may be discharged as a fog-like or mist-like liquid and, furthermore, be discharged in the shape of fumes.

In the method for patterning of the positive hole transport layer 140A, luminescent layer 140B, and electron transport layer 140C with such a patterning apparatus 1, since these materials are discharged, for example, in the condition of being vaporized, by discharging each of the materials for formation from the nozzle 3 into the vacuum atmosphere, when this material is ejected onto the substrate, patterning can be performed without the use of any mask. Furthermore, when each of the materials for formation is vaporized and is ejected, the material can be used without the need for any solvent. Consequently, each of low-molecular-based materials and macromolecular-based materials can be patterned without particular restriction and, therefore, the positive hole transport layer 140A, luminescent layer 140B, and electron transport layer 140C can be formed.

Since discharge of each of the materials for formation is performed intermittently, patterning of the positive hole transport layer 140A, luminescent layer 140B, and electron transport layer 140C can be performed easily with respect to many pixels 1A independent of each other.

Since each of the materials for formation is discharged from the nozzle hole 3a while accompanying the carrier gas, the material can be discharged with reliability and, in addition, be arranged at a desired position with further reliability. Consequently, the precision of patterning can be improved.

Regarding such a patterning apparatus 1, since the aforementioned method for patterning can be performed, each of low-molecular-based materials and macromolecular-based materials can be patterned without particular restriction and, therefore, regarding formation of the positive hole transport layer 140A, luminescent layer 140B, and electron transport layer 140C, selection of the materials thereof can be performed with a high degree of flexibility. Since the material is discharged (ejected) in the condition of being vaporized and is patterned, each material for formation can be used without the need for any solvent and, therefore, inconveniencies in that, for example, the life of an electro-optic apparatus provided with the resulting organic electroluminescent element is reduced due to a solvent can be avoided.

Since the heating device 9 for heating the material is arranged in the material supply chamber 7, by heating the material with this heating device 9, the material is allowed to vaporize more easily during discharge and, therefore, even the material unlikely to vaporize can be vaporized with reliability and be patterned.

Since the carrier gas supply source 8 is arranged in the material supply chamber 7, by allowing the material discharged in the shape of a molecular beam to accompany the carrier gas, the material can be arranged at a desired position with further reliability and, therefore, the precision of patterning can be improved.

Regarding the method for manufacturing an electro-optic apparatus using the method for patterning with such a patterning apparatus 1, as described above, each of low-molecular-based materials and macromolecular-based materials can be patterned without particular restriction and, therefore, regarding formation of the positive hole transport layer 140A, luminescent layer 140B, and electron transport layer 140C, selection of the materials thereof can be performed with a high degree of flexibility. Since the material is discharged (ejected) in the condition of being vaporized and is patterned, each material for formation can be used without the need for any solvent and, therefore, inconveniencies in that, for example, the life of an electro-optic apparatus provided with the resulting organic electroluminescent element is reduced due to a solvent can be avoided.

In the aforementioned patterning apparatus 1, the example in which the vacuum chamber 2 is provided with one nozzle 3 was shown. However, the present invention is not limited to this, and a plurality of nozzles 3 may be arranged in the configuration. A head provided with many nozzles 3 may be arranged.

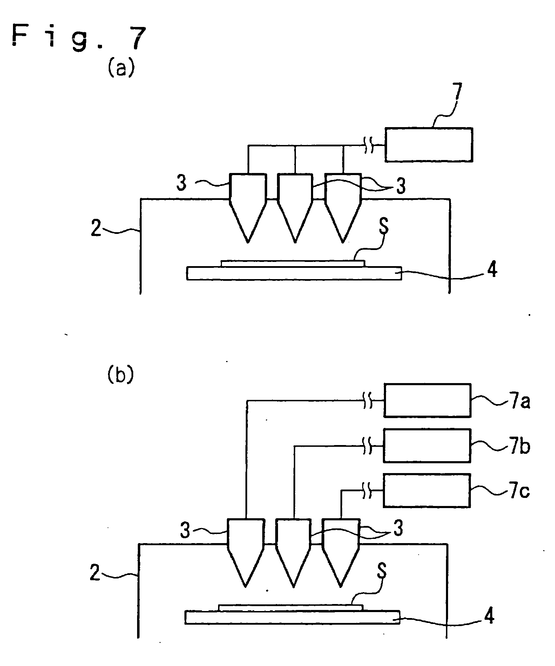

Fig. 7(a) is a schematic diagram showing an example in which the vacuum chamber 2 is provided with three nozzles 3, and in this example, three nozzles 3·· are connected to the same material supply chambers 7. According to such a configuration, the same material can be discharged from three nozzles 3·· toward the substrate S and, therefore, it becomes possible to enlarge the region in which the material can be discharged and arranged at a time, and to increase the quantity of supply of the material on a span of time basis. Consequently, improvement of the throughput can be achieved.

Fig. 7(b) is a schematic diagram showing an example in which the three nozzles 3·· arranged in the vacuum chamber 2 are connected to the respective material supply chambers 7a, 7b, and 7c different from each other. According to such a configuration, respective materials different from each other can be discharged from the three nozzles 3·· toward the substrate S and, therefore, patterning can be performed on the substrate S with different three materials. For example, when the luminescent layers in the aforementioned organic electroluminescent element are formed on the substrate, materials for forming a luminescent layer corresponding to respective colors, red (Red), green (Green), and blue (Blue), are discharged individually from different nozzles and, therefore, the luminescent layers corresponding to respective colors can be formed on the substrate with a predetermined arrangement pattern.

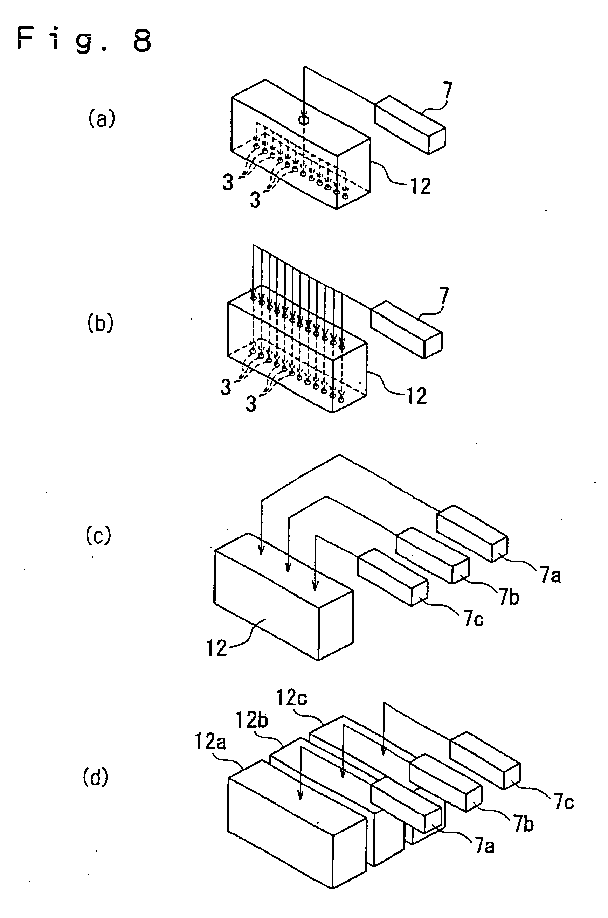

In the present invention, when a plurality of nozzles 3 are arranged, these nozzles 3 may be arranged together on the same substance, and this substance may be attached to the vacuum chamber 2. Figs. 8(a) to (d) schematically show configuration examples of discharge heads 12 as the aforementioned substance provided with a plurality of nozzles 3.

The discharge head 12 shown in Fig. 8(a) is connected to a single material supply chamber 7. The material supplied from the material supply chamber 7 is branched in the discharge head 12 and, thereafter, is fed to each of the nozzles 3.

The discharge head 12 shown in Fig. 8(b) is connected to a single material supply chamber 7. The material supplied from the material supply chamber 7 is branched before entrance into the discharge head 12, and is fed to each of the nozzles 3 without further branching in the discharge head 12. In this example, unevenness in the energy loss due to branching in the discharge head 12 is avoided and, therefore, discharge of the material from individual nozzles 3 can be performed more uniformly.

The discharge head 12 shown in Fig. 8(c) is connected to a plurality of material supply chambers 7a, 7b, and 7c different from each other. The material supplied from each of the material supply chambers 7a, 7b, and 7c is fed to a predetermined nozzle brought into correspondence with the material in advance among a plurality of nozzles arranged in the discharge head 12.

A plurality of discharge heads (12a, 12b, and 12c) are shown in Fig. 8(d), and are connected individually to different material supply chambers 7a, 7b, and 7c, respectively. Such configurations of the discharge heads 12 and supply routs of the materials are determined appropriately in accordance with the materials to be used. Regarding the plurality of nozzles 3 arranged in the discharge head 12, the timings of discharge of the materials are controlled individually by the discharge mechanism 10 (refer to Fig. 1).

According to the patterning apparatus provided with a plurality of nozzles 3 as described above, the region in which the material can be discharged and arranged (patterned) at a time can be enlarged and, therefore, the quantity of supply of the material on a span of time basis can be increased, or different materials can be discharged at the same time. Consequently, improvement of the throughput can be achieved.

When the plurality of nozzles 3 and the substrate S can be relatively moved, and the plurality of nozzles 3 can be positioned individually relative to the substrate S, the material can be arranged with reliability at a predetermined position on the substrate S from any one of the nozzles 3.

When the plurality of nozzles 3 are connected to the respective material supply chambers 7a, 7b, and 7c different from each other, in the case where different materials are discharged and arranged on the substrate S, patterning of the different materials can be performed with ease only by switching the nozzles 3 to be actuated without taking the substrate S in and out of the vacuum chamber 2.

When three or more of nozzles 3 are arranged, regarding the configuration, it is not especially necessary to allow all of the nozzles 3 to discharge the same material, or to allow all of the nozzles to discharge materials different from each other. Regarding the configuration, at least two nozzles of three or more of nozzles 3 may be allowed to discharge the same material and, in addition, at least two nozzles 3 may be allowed to discharge different materials.

According to this, both of the aforementioned effects, that is, the effect of reducing throughput and the effect that patterning of the different materials can be performed easily without taking the substrate S in and out of the vacuum chamber 2, can be exerted.

Electronic apparatuses of the present invention, for example, electro-optic apparatuses, e.g., organic electroluminescent elements, and electronic apparatuses including electronic elements, e.g., transistors and diodes, can be manufactured by patterning various constituents with the patterning apparatus 1 having the aforementioned single or plurality of nozzles 3.

Regarding the electronic apparatus thus manufactured, since manufacture is performed using the aforementioned patterning apparatus 1, each of low-molecular-based materials and macromolecular-based materials can be selected without particular restriction in the patterning.

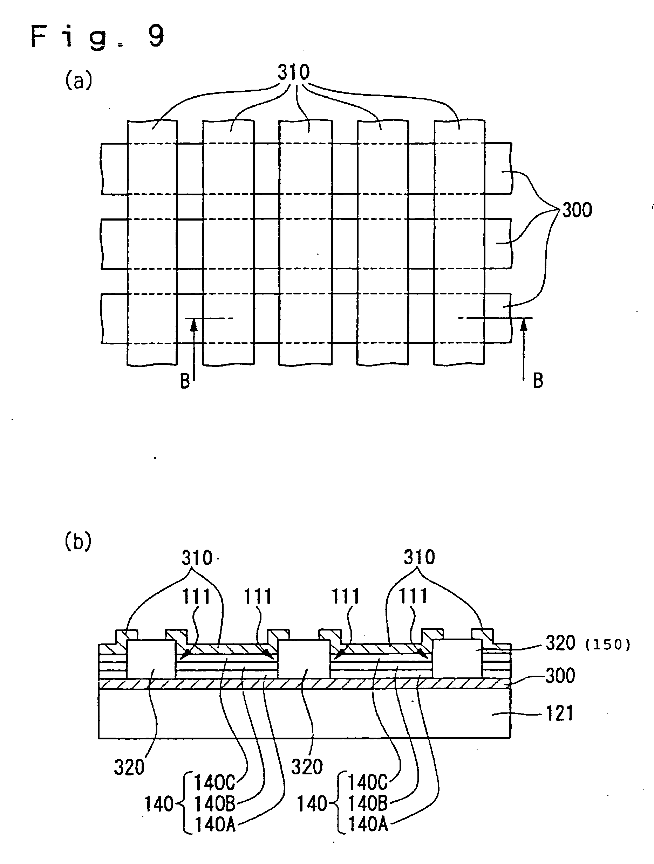

Fig. 9 is a diagram showing another example in which the patterning with the aforementioned patterning apparatus 1 is applied to manufacture of an electro-optic apparatus, that is, showing an example in which the electro-optic apparatus according to the present invention is applied to a display device of passive matrix type using an organic electroluminescent element. Fig. 9(a) is a plan view showing the arrangement relationship between a plurality of first bus wirings 300 and a plurality of second bus wirings 310 arranged in the direction orthogonal thereto, and Fig. 9(b) is a sectional view of the section indicated by a line B-B shown in Fig. 9(a). The same configurations as those shown in Fig. 2 to Fig. 6 are indicated by the same reference numerals and explanations thereof are omitted. Since the manufacturing step is also the same as that in the aforementioned example, illustration and explanations thereof are omitted essentially.

That is, in the present example, the partition wall 150 composed of an insulation film 320 of SiO₂, for example, is arranged surrounding the predetermined position at which the luminescent portion 140 is to be arranged and, thereby, the height difference 111 has been formed between the predetermined position and the periphery thereof. Even in a display device having such a configuration, in a manner similar to that in the aforementioned example, each of low-molecular-based materials and macromolecular-based materials can be patterned without particular restriction as the material for forming the positive hole transport layer 140A, luminescent layer 140B, and electron transport layer 140C. Consequently, regarding formation of these positive hole transport layer 140A, luminescent layer 140B, and electron transport layer 140C, selection of the materials thereof can be performed with a high degree of flexibility. Furthermore, each material for formation can be used without the need for any solvent and, therefore, inconveniencies in that the life of an electro-optic apparatus provided with the resulting organic electroluminescent element is reduced due to a solvent can be avoided.

In the aforementioned example, the positive hole transport layer 140A was formed as the layer under the luminescent layer 140B, and the electron transport layer 140C was formed as the layer above the luminescent layer 140B. However, the present invention is not limited to this, and, for example, only one of this positive hole transport layer 140A and the electron transport layer C may be formed, and the positive hole injection layer may be formed in addition to the positive hole transport layer 140A as described above.

In the aforementioned example, the partition wall 150, which separates pixels 1A from each other, was formed from the signal line 132, common feeder line 133, scanning lines, and interlayer insulation film 240 covering this, or the partition wall 150 was formed from the insulation film 320. However, the present invention is not limited to this and, for example, the partition wall may be formed from a resin black resist, etc., and the positive hole transport layer and luminescent layer may be formed without formation of the partition wall.

Next, specific examples of electronic equipment provided with the electro-optic apparatus using the organic electroluminescent element in the aforementioned example will be described.

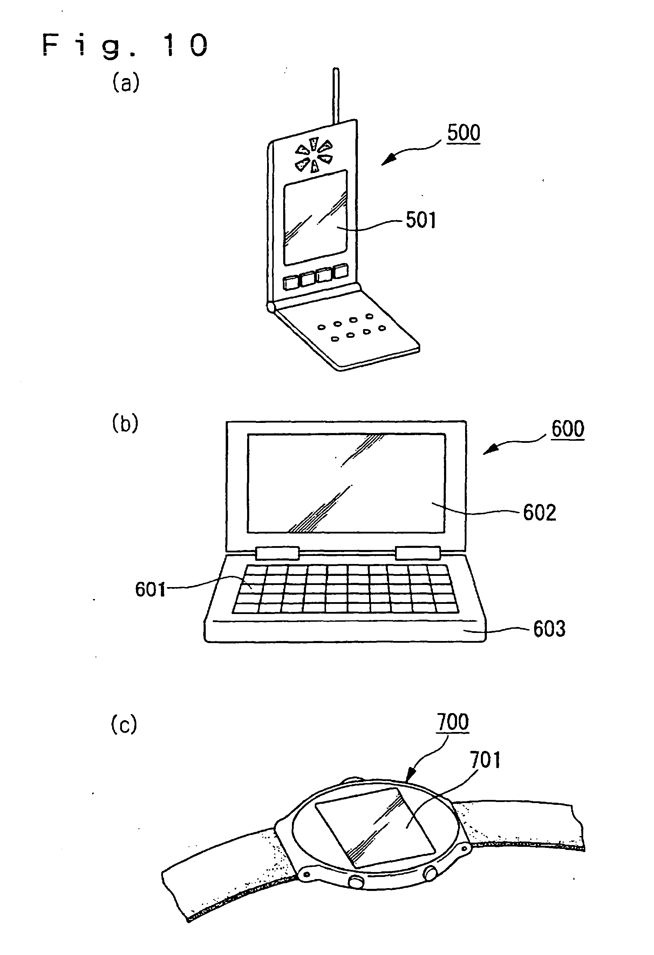

Fig. 10(a) is a perspective view showing an example of a cellular phone. In Fig. 10(a), reference numeral 500 denotes a cellular phone body, and reference numeral 501 denotes an electroluminescent display portion (display means) provided with a display device shown in Fig. 2 and Fig. 3.

Fig. 10(b) is a perspective view showing an example of portable information processing apparatuses, for example, word processors and personal computers. In Fig. 10(b), reference numeral 600 denotes an information processing apparatus, reference numeral 601 denotes an input portion, for example, a keyboard, reference numeral 603 denotes an information processing body, and reference numeral 602 denotes an electroluminescent display portion (display means) shown in Fig. 2 and Fig. 3.

Fig. 10(c) is a perspective view showing an example of wristwatch type electronic equipment. In Fig. 10(c), reference numeral 700 denotes a watch body, and reference numeral 701 denotes an electroluminescent display portion (display means) shown in Fig. 2 and Fig. 3.

The electronic equipment shown in Figs. 10(a) to (c) are provided with the aforementioned electro-optic apparatus and, therefore, become the electronic equipment provided with the display device capable of exhibiting excellent display quality.

As described above, according to the method for patterning of the present invention, since the material is discharged into the vacuum atmosphere which is an atmosphere at a pressure adequately lower than that in the nozzle, this material can be discharged in the condition of being vaporized and ideally in the shape of a molecular beam. Therefore, patterning can be performed without any mask, by ejecting this material onto the substrate while relative positions of the nozzle and the substrate are controlled. Consequently, even a material unlikely to dissolve into a solvent can be patterned without particular restriction.

According to another method for patterning of the present invention, in addition to the effects by the aforementioned method for patterning, in particular, since a plurality of nozzles are connected to the material supply source, it is possible to enlarge the region in which the material can be arranged at a time, to increase the quantity of supply of the material on a span of time basis, or to discharge simultaneously different materials and, therefore, improvement of the throughput can be achieved.

According to the method for forming a film and the film formation apparatus of the present invention, contamination of impurities from the outside can be reduced and, at the same time, films can be formed in accordance with a plurality of regions on the aforementioned substrate, or reduction of the film formation step can be achieved.

According to the patterning apparatus of the present invention, since the material is discharged into the vacuum chamber in which a pressure of the atmosphere becomes adequately lower than that in the nozzle, this material can be discharged with ease and with stability. Therefore, patterning can be performed without any mask, by ejecting the material onto the substrate while relative positions of the nozzle and the substrate are moved with the movement mechanism, and since the material is vaporized, the material can be used without any solvent. Consequently, even a material unlikely to dissolve into a solvent can be patterned without particular restriction.

According to another patterning apparatus of the present invention, in addition to the effects by the aforementioned patterning apparatus, in particular, due to the configuration in which a plurality of nozzles are arranged, it is possible to enlarge the region in which the material can be arranged at a time, to increase the quantity of supply of the material on a span of time basis, or to discharge simultaneously different materials and, therefore, improvement of the throughput can be achieved.

According to the method for manufacturing an electro-optic apparatus of the present invention, by applying a coating of the material on the substrate while relative positions of the nozzle and the substrate are controlled as described above, patterning can be performed without the need for any mask. Consequently, each of low-molecular-based materials and macromolecular-based materials can be patterned without particular restriction. In particular, when a material for forming at least one of the electron transport layer, positive hole transport layer, luminescent layer, and electrode constituting the organic electroluminescent element is discharged as the material so as to pattern the electron transport layer, positive hole transport layer, luminescent layer, or electrode, the material for forming the electron transport layer, positive hole transport layer, luminescent layer, or electrode can be selected with a high degree of flexibility. When the electron transport layer, positive hole transport layer, luminescent layer, or electrode is formed without the use of any solvent, extension of the life of the resulting element can be achieved.

According to the electro-optic apparatus of the present invention, since each of low-molecular-based materials and macromolecular-based materials is patterned without particular restriction and, therefore, at least a part of the constituents thereof is formed as described above, the degree of flexibility in selection of the material is increased in manufacture.

In the electronic equipment of the present invention as well, especially regarding the display device thereof, the degree of flexibility in selection of the material is increased in manufacture as described above.

According to the electronic apparatus of the present invention and the method for manufacturing the same, since manufacture is performed using the aforementioned patterning apparatus, regarding the patterning thereof, even a material unlikely to dissolve into a solvent can be selected without particular restriction.

## Claims

1. A film formation apparatus for forming a plurality of films, comprising:
a chamber capable of being adjusted at a degree of vacuum of 0.133 Pa or less;
a first nozzle;
a substrate stage that is arranged in the chamber and holds a substrate; and
a movement mechanism that moves at least one of the first nozzle and the substrate stage,
wherein the film formation apparatus is configured such that:
a plurality of positions of the first nozzle relative to the substrate is capable of being set; and
the plurality of films can be formed by ejecting a first material that is included in the plurality of films or is a precursor of the plurality of films from the first nozzle at each of the plurality of positions.

2. The film formation apparatus according to claim 1, further comprising a second nozzle.

3. The film formation apparatus according to claim 2, wherein the first nozzle and the second nozzle are connected to a first material supply source.

4. The film formation apparatus according to claim 2, wherein the first nozzle and the second nozzle are connected to a first material supply source and a second material supply source, respectively.

5. The film formation apparatus of any one of claims 1 to 4, wherein the film formation apparatus is configured such that the first material is ejected from the first nozzle intermittently.
